(19) Europäisches Patentamt
European Patent Office
Office européen des brevets

(11) **EP 0 701 269 B1**

(12) **EUROPEAN PATENT SPECIFICATION**

(45) Date of publication and mention
of the grant of the patent:
**26.03.1997 Bulletin 1997/13**

(51) Int Cl.⁶: **H01J 37/317**

(21) Application number: **95115720.5**

(22) Date of filing: **17.08.1990**

(54) **Ion implantation apparatus**

Ionimplantationsgerät

Appareil d'implantation ionique

(84) Designated Contracting States:
**DE GB IT**

(30) Priority: **17.08.1989 JP 211832/89**
**12.01.1990 JP 5191/90**
**27.04.1990 JP 114307/90**

(43) Date of publication of application:
**13.03.1996 Bulletin 1996/11**

(62) Application number of earlier application in
accordance with Art. 76 EPC: **90115837.8**

(73) Proprietors:
- **MITSUBISHI DENKI KABUSHIKI KAISHA**
  **Tokyo 100 (JP)**
- **NISSHIN DENKI KABUSHIKI KAISHA**
  **Ukyo-ku, Kyoto-shi, Kyoto-fu (JP)**

(72) Inventors:
- **Shono, Kazuhiro, c/o Mitsubishi Denki K.K.**
  **8-chome, Amagasaki-shi, Hyogo-ken (JP)**
- **Sasaki, Shigeo, c/o Mitsubishi Denki K.K.**
  **8-chome, Amagasaki-shi, Hyogo-ken (JP)**
- **Katoh, Susumu, c/o c/o Mitsubishi Denki K.K.**
  **Itami-shi, Hyogo-ken (JP)**
- **Naitou, Masao, c/o Nisshin Denki K.K.**
  **Kyoto-shi, Kyoto-fu (JP)**
- **Nakanishi, Tetsuya, c/o Mitsubishi Denki K.K.**
  **Amagasaki-shi, Hyogo-ken (JP)**
- **Fujishita, Naomitsu, c/o Mitsubishi Denki K.K.**
  **8-chome, Amagasaki-shi, Hyogo-ken (JP)**
- **Noguchi, Kazuhiko, c/o Mitsubishi Denki K.K.**
  **8-chome, Amagasaki-shi, Hyogo-ken (JP)**
- **Tanjo, Masayasu, c/o Nisshin Denki K.K.**
  **Kyoto-shi, Kyoto-fu (JP)**

(74) Representative:
**TER MEER - MÜLLER - STEINMEISTER &**
**PARTNER**
**Mauerkircherstrasse 45**
**81679 München (DE)**

(56) References cited:
- **NUCLEAR INSTRUMENTS & METHODS IN PHYSICS RESEARCH, SECTION - B: BEAM INTERACTIONS WITH MATERIALS AND ATOMS, vol. 37/38, no. 2, February 1989 AMSTERDAM NL, pages 612-615, S SATOH ET AL. 'Ion beam systems for the new high current ion implantation system EXTRION-1000'**
- **R G WILSON ET AL. 'IOn beams, with applications to ion implantation' 1973 , JOHN WILEY & SONS, INC , USA * page 159 ***
- **PATENT ABSTRACTS OF JAPAN vol. 12 no. 115 (E-599) ,12 April 1988 & JP-A-62 243231 (MITSUBISHI ELECTRIC CORP) 23 October 1987,**

## Description

The present invention relates to an ion implantation apparatus.

Such kind of ion implantation apparatus is already known from: Nuclear Instruments and Methods in Physics Research. Vol. B 37/38, 1989, pages 612 - 615. Said known ion implantation apparatus comprising:

- an ion source comprising an arc chamber generating ions and a drawing electrode drawing ions from said arc chamber;

- a mass separator transporting only such ions of the drawn ions which are necessary for implantation to a material into which ions shall be implanted:

- an ion implantation chamber in which said material is arranged; and

- a controlling means for controlling the amount of current and the current density distribution of the ion beam provided by said ion source;

wherein said controlling means is arranged to adjust said amount of current and the current density distribution by controlling the distance d between said arc chamber and said drawing electrode.

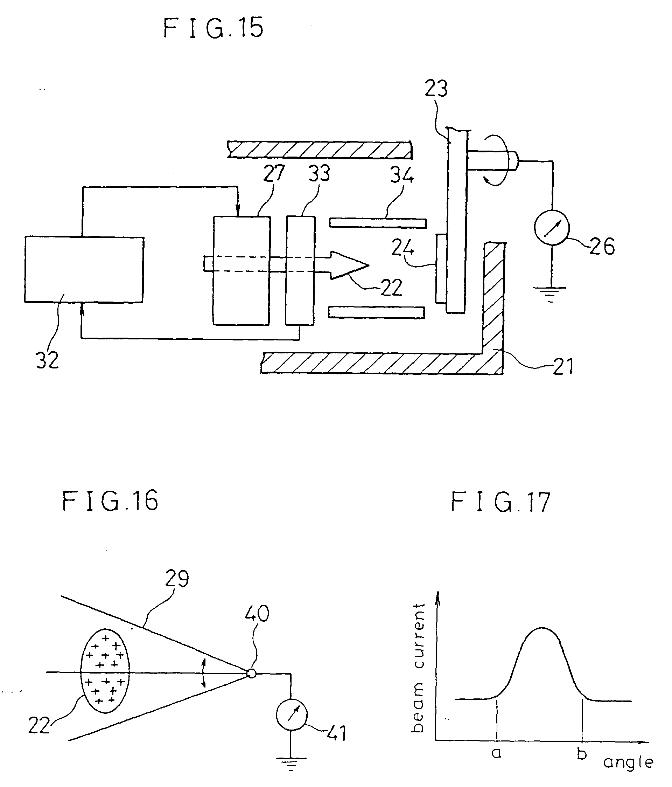

Figure 15 is a diagram showing another example of a conventional ion implantation apparatus disclosed in, for example Japanese Patent Laid Open Gazette No. 62-241247. In figure 15, an ion beam 22 is applied to an ion implantation chamber 21 and corrected by an ion beam correcting lense 27. Thereafter, the corrected ion beam 22 passes through an ion beam measuring means 33 which functions as a sensor of a controller 32 for controlling the ion beam correcting lense 27. Then, the ion beam 22 passes through a Faraday cage 34 and is implanted in a disc 24 arranged on a rotary disc 23. This rotary disc 23 is connected to an ion beam ampere meter 26.

Then, operation thereof will be described In detail hereinafter.

The ion beam 22 is applied from the left side of figure 15 to the ion implantation chamber 21 and then implanted in the wafer 24 arranged on the rotary disc 23. The disc 23 serves as a bottom of the Faraday cage 34 and an amount of ion beam applied to the Faraday cage 34 can be measured by the ion beam ampere meter 26 connected to the disc 23. The ion beam 22 passes through the ion beam correcting lens 27 and the ion beam measuring means 33 just before it reaches the Faraday gage 34.

Figure 16 is a view showing the ion beam measuring means 33 seen from the side of the wafer 24. Referring to figure 16, a probe 29 formed of a high melting point metal is driven by a motor 40 so as to be rotated by an appropriate angle and vertically crosses the ion beam 22, whereby a current flows through the ampere meter 41. A potentiometer and a rotary encoder are attached on the motor 40 and then a signal obtained by the ampere meter 41 is monitored by an oscilloscope with appropriate synchronization, with the result that waveform shown in figure 17 is obtained. Thus, a vertical length, a position, and an approximate configuration of the ion beam can be obtained from the waveform and positions a and b in figure 17. The computer 32 receives this information and controls the ion beam correcting lens 27, whereby the ion beam 22 is corrected.

However, since the ion beam correcting lens 27 is inserted in front of the rotary disc 23 in the above conventional ion implantation apparatus, size of the apparatus is increased and a structure thereof becomes complicated, with the result that production cost is increased. In addition, when the beam correcting lens 27 is inserted, a beam transporting distance is increased, so that the number of ions which collide with neutral particles and scatter during its transportation is increased. As a result, transporting efficiency of the beam is reduced. In order to prevent it, the correcting lens has to be dispensed with so that the transporting distance of the beam may be short, particularly in a large current type ion implantation apparatus which makes great account of the transporting efficiency of the beam, like a predeposition type ion implantation apparatus (disclosed in, for example "Electron and Ion Beam Handbook") which is the main current in the present. However, if there is no ion beam correcting lens, it is difficult to appropriately control a current and current density of the ion beam.

Ion implantation apparatuses not requiring an ion correcting lens, but which can anyhow appropriately control the current and current density of an ion beam are known from Patent Abstracts of Japan. Vol. 13, No. 150 (E-742) (3498) (Abstract for JP-A-63-310549) and from Patent Abstracts of Japan. Vol. 12, No. 115 (E-599) (2962) (Abstract for JP-A-6- 243231). The apparatus described in the former reference comprises a current measuring means and shims which are rotated by a shim driving control in a way to adjust the measured ion current to a specified value. In the apparatus of the latter reference. a certain ion beam current is set and then the ion beam current density is measured at a plurality of points. When a certain current density is desired when operating the apparatus, the corresponding ion beam current is set.

It is the object of the invention to provide an ion implantation apparatus capable of controlling the amount of current and current density distribution of an ion beam with a simple structure having no ion beam correcting lens.

The ion implantation apparatus of the present invention is defined by the teaching of appended claim 1. In this apparatus, the controlling means is arranged to adjust the distance between the arc chamber and the drawing electrode. The control is performed in an open loop manner by calculating and controlling the distance based on different parameters.

BRIEF DESCRIPTION OF THE DRAWINGS

Figure 1 is a view showing a structure of an ion implantation apparatus similar to, however not in accordance with the present invention;

Figure 2 is a view showing an example of control algorithm for controlling an ion beam by adjusting the distance between an arc chamber and a beam drawing electrode in accordance with a theoretical calculation using conception of normalization perveance at a beam drawing part;

Figure 3 is a view showing an example of control algorithm for controlling the ion beam by adjusting the distance between the arc chamber and the beam drawing electrode and an incident angle and an outputting angle of a mass separator;

Figure 4 is a view showing an example of control algorithm for controlling the ion beam by adjusting the distance between the arc chamber and the beam drawing electrode and the incident angle and the outputting angle of the mass separator in accordance with a theoretical calculation and by performing feedback control using an ion current density distribution measuring apparatus;

Figure 5 is a view showing an example of control algorithm for controlling the ion beam by adjusting the distance between the arc chamber and the beam drawing electrode and the incident angle and the outputting angle of the mass separator in accordance with a theoretical calculation and by performing feedback control using the ion current density distribution measuring apparatus so as not to exceed a set maximum current density;

Figure 6 is a view showing the correlation between an amount of implantation current and a current density distribution;

Figure 7 is a view showing the relation between the distance between the drawing electrode and the arc chamber, a drawing current and normalization perveance;

Figure 8 is a view showing a two-dimensional current density distribution when the normalization perveance and the beam current are used as parameters;

Figure 9 is a view showing an example of an ion implantation apparatus comprising a conventional mass separator;

Figure 10 is a view showing a structure of an ion implantation apparatus in accordance with an embodiment of the present invention;

Figure 11 is a view showing the relation between a distance d between an arc chamber and a beam drawing electrode, a current and a current density distribution of a beam In the apparatus of Fig. 10;

Figure 12 is a view showing an accumulated beam current distribution in the disc scanning direction when d is i through iv;

Figure 13 Is a view showing a control structure of a mass separator of an ion implantation apparatus similar to, however not in accordance with the present invention;

Fig. 14 is a view showing a structure of an ion implantation apparatus similar to, however not in accordance with the present invention;

Figure 15 is a view showing an example of an ion implantation apparatus comprising a conventional ion beam correcting lense;

Figure 16 is a view showing ion beam measuring means of the apparatus in figure 15; and

Figure 17 is a view showing a current density distribution detected by the ion beam measuring means in figure 16 and monitored by an oscilloscope.

DETAILED DESCRIPTION OF THE PREFERRED EMBODIMENT

Embodiments of the present invention will be described in detail in reference to the drawings hereinafter.

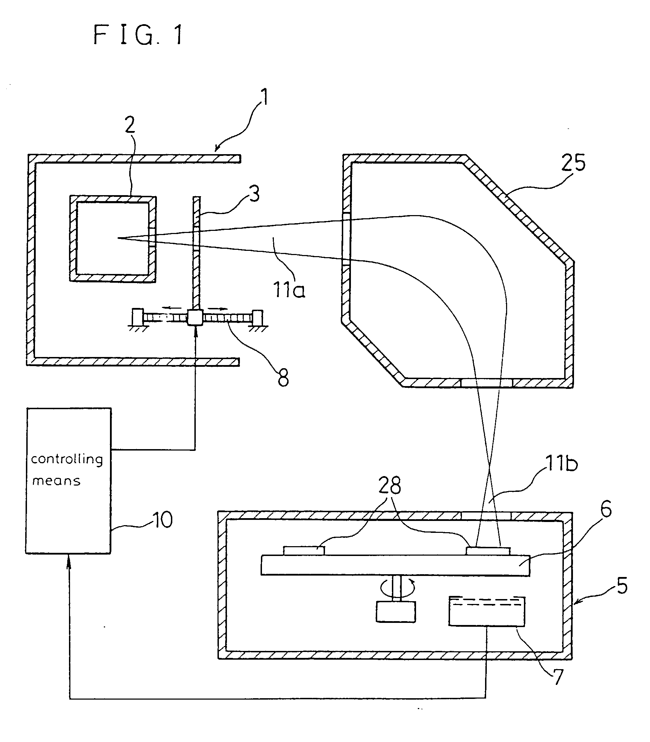

Figure 1 is a view showing a structure of an ion implantation apparatus similar to, however not in accordance with the present invention. In figure 1, an ion source 1 comprises an arc chamber 2 generating ions and a drawing electrode 3 drawing ions from the arc chamber 2. A mass separator 25 takes out an ion beam llb having required ions from an ion beam 11a drawn by a drawing electrode 3 and then the ion beam 11b is applied to an ion implantation chamber 5. A rotary disc 6 is provided in the ion implantation chamber 5 and a wafer 28 is put on the rotary disc 6. An ion beam measuring means 7 is provided at the lower part of the rotary disc 6. A controlling means 10 controls a drawing electrode driving means 8 in accordance with a data obtained by the ion beam measuring means 7.

Then, operation thereof will be described in detail hereinafter.

Ions generated from the arc chamber 2 in the ion source 1 are drawn by the beam drawing electrode 3 and then radiated as an ion beam 11a. The ion beam 11a passes through a mass separator 25 and then an ion beam llb having required ions is only applied to the ion implantation chamber 5. The ions applied to the ion implantation chamber 5 are implanted in the wafer 28 put on the rotary disc 6 in the ion implantation chamber 5.

The ion beam measuring means 7 for measuring an amount of current and a current density distribution of the ion beam is provided at the lower part of the rotary disc 6 corresponding to the position to which the ion beam 11b is applied. Data obtained by the ion beam measuring means 7 is received and processed by the controlling means 10, whereby the drawing electrode driving means 8 is controlled. As a result, the distance between the arc chamber 2 and the drawing electrode 3 is adjusted and the ion beams 11a and llb are corrected.

It is considered that the ion beam can be measured with highest precision when, for example a method of scanning an ion beam detector of a multihole Faraday type is used as the ion beam measuring means 7. However, the same type as that of the ion beam measuring means 33 in a conventional apparatus shown in figure 15 may be used.

Referring to figure 1, the ion beam is drawn out of the arc chamber 2 by the beam drawing electrode 3. Since the ion beam consists of positive electric charges, when especially an ion density is high, the ion beam scatters by repulsive force of ions. This phenomenon is generally called "divergence caused by a space charge of an ion". First, control (a primary control) is performed in disregard of the divergence of beam caused by the space charge. A distance D between a beam drawing electrode 3, which provides a minimum beam divergence angle when the divergence of beam caused by the space charge is not regarded, and an arc chamber 2 is found by a theory and a numeral expression described by Junzo Ishikawa, in "Ion Source Engineering", pp.178-186 published by Ionics Kabushiki Kaisha as follows.

$$D = 2 \left( \frac{SC_\varepsilon O}{9I} \right)^{1/2} (2\alpha V^3)^{1/4}$$

where S is an area of a drawing hole, C is a constant which is 0.6 when the drawing hole is a circle and 0.68 when it is a slit, $\varepsilon_0$ is a dielectric constant of a vacuum, $\alpha$ is an effective specific charge, I is a drawing current and V is a drawing voltage.

The above effective specific charge $\alpha$ is expressed as follows.

$$\alpha^{-1/2} I = \Sigma_i \left( \frac{m_i}{Z_i e} \right)^{1/2} I_i$$

where $m_i$, $Z_i$ and $I_i$ are mass, ionization number and an amount of current of each ion comprised in I respectively and e is a prime charge.

S and C in the above equation are constants decided depending on each apparatus and V and I are set as implantation conditions. If $\alpha$ in accordance with I is obtained by an experiment or the like, controlling means 10 calculates a value of D by several arithmetic operation and the position of the beam drawing electrode 3 is adjusted by driving means 8, whereby the beam drawing operation when the divergence caused by the space charge can be disregarded can be implemented with the best convergence. The above is the primary control.

In addition, $\alpha$ can be easily found by an experiment using a mass separator 25.

The drawn ion beam passes through the mass separator 25, whereby a beam having required ions is only separated. Thereafter, it is applied to the wafer 28 on the rotary disc 6 arranged in the ion implantation chamber 5. The ion beam measuring means 7 measures an amount of current and a current density distribution of the beam radiated to the wafer 28. At this time, if divergence of the beam caused by the space charge can be disregarded, the measured amount of current shows a maximum value.

However, when an effect of the space charge can not be disregarded and the amount of current is not maximum or when there is considerable variation in the current density even if the amount of current is maximum and this variation should be corrected, the following more precise control, that is, a secondary control is performed as follows.

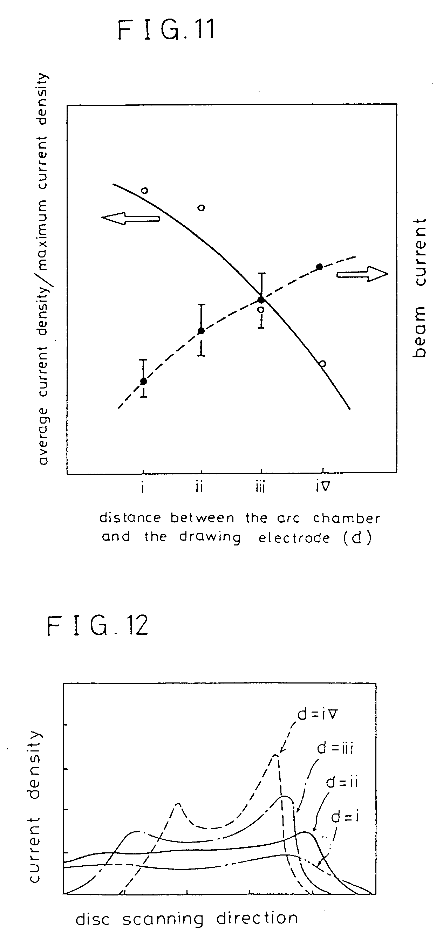

Figure 11 is a graph showing d (the distance between the arc chamber and the drawing electrode) dependency of an amount of current and a current density distribution of an ion beam which are measured by the ion beam measuring means 7. The horizontal axis in figure 11 shows that d is increased at equal intervals in the order of i, ii, iii and iv. Figure 12 shows a current density distribution of an accumulated beam in the disc scanning direction at each position of i through iv. As can be seen from figures 11 and 12, variation of d has the same effect to the beam as that of a convergent lens. Therefore, when the value of d is varied in the iv direction and then the controlling means 10 performs feedback control, the amount of current measured by the ion beam measuring means 7 may be maximum. In addition, when the current density distribution is made uniform, the value of d is varied in the i direction and the controlling means 10 performs feedback control while monitoring the current density distribution of the ion beam measuring means 7. As a monitoring parameter at this time, for example a value of a maximum current density or maximum current density / average current density is set and then a maximum amount of current which does not exceed that set value can be obtained by the controlling means 10.

As described above, since the ion beam can be adjusted without the ion beam correcting lens, the beam transporting distance is not increased. Therefore, the amount of current and the current density distribution of the ion beam can be automatically controlled, while the beam transporting efficiency is not reduced.

It is needless to say that the above control can be applied to a serial control in which continuous control is implemented in real time or to batch process in which an ion beam is adjusted at appropriate intervals of time.

Although the above control is performed by monitoring the ion beam after mass separation, the beam before the mass separation may be monitored. At this time, especially when the current density distribution is controlled, it is necessary to previously find correlation of the current density distributions of the ion beam before and after the mass separation by calculation or the like.

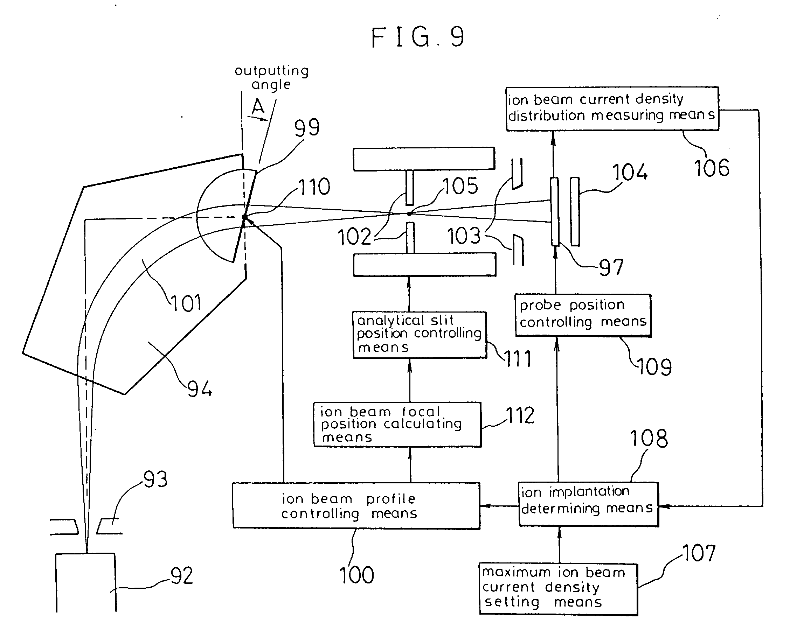

Figure 9 is a view showing a conventional ion implantation apparatus disclosed in, for example Japanese Patent Publication Gazette No. 62-243231. In figure 9, an ion beam 101 is drawn from an ion source arc chamber (ion source) 92 by a drawing electrode 93. Then, an advancing direction of the ion beam 101 is curved by a mass separator (analyzer magnet) 94 and an outputting angle thereof is varied by a pole chip 99. The outputted ion beam 101 passes through a movable analytical slit 102 and a molding slit (mask) 103 and reaches an ion beam current density measuring apparatus (probe) 97 and a wafer 104. An ion beam current density distribution measuring means 106 measures an ion beam current density by the probe 97. An ion implantation determing means 108 judges as to whether an ion implantation can be performed or not in accordance with a value of the ion beam current density and a value of maximum ion beam current density measured by a maximum ion beam current density measuring means 107. When the result is that implantation can be performed, a probe position controlling means 109 controls a position of the probe 97. When the result is that implantation cannot be performed, an ion beam profile controlling means 100 controls an outputting angle of the pole chip 99 and an ion beam focal position calculating means 112 calculates a focal position of the ion beam. Then, an analytical slit position controlling means 111 varies a position of an analytical slit 102 in accordance with the calculation result.

Next, operation thereof will be described in detail hereinafter.

The ion source 92 generates plasma of impurity ions and the drawing electrode 93 draws the ion beam 101 from the plasma. The analyzer magnet 94 generates a magnetic field in the direction vertical to the ion beam 101 and curves the advancing direction of the ion beam 101. The pole chip 99 varies an outputting angle A of the ion beam 101 around the rotation axis 110 of the pole chip. The position of the focal point 105 of the ion beam gets near to or away from the analyzer magnet 94 by this variation of the outputting angle A. The analytical slit 102 analyzes the ion beam 101 and increases purity of the ion beam 101. The mask 103 prevents the ion beam 101 from spreading beyond necessity. The probe 97 receives the ion beam 101 before ion implantation is performed on the semiconductor wafer 104 on which an MOS-IC or the like is formed and then the ion beam current density distribution is measured by the ion beam current density distribution measuring means 106. Then, a value of a maximum ion beam current density is set by the maximum ion beam current density setting means 107 and this value and a measured value are determined by the ion implantation determining means 108. When the result is that implantation can be performed, a position of the probe 97 is controlled by the probe position controlling means 109. On the other hand, when the result is that implantation can not be performed, the ion beam profile controlling means 100 moves the pole chip 99.

As described above, the ion beam maximum current density distribution is controlled so that yield is prevented from being reduced by electrostatic breakdown.

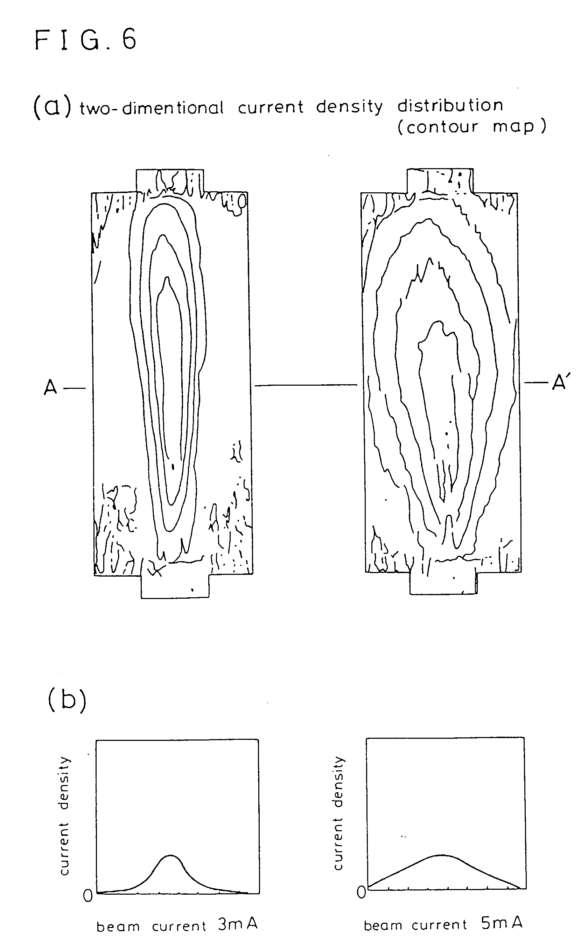

However, it is not possible to apply the controlling method for the conventional apparatus to an ion implantation apparatus which does not have the beam current density distribution measuring apparatus. In addition, since profile of the beam is controlled by only the beam outputting angle of the mass separator, that control is only for the vertical or horizontal direction of the beam, so that it is not possible to automatically control the beam in the horizontal and vertical directions at the same time. Furthermore, although an electrostatic breakdown coefficient depends on the maximum current density and productivity depends on an amount of implantation current, the above control is only for the maximum current density, more specifically, the control gives consideration only to the electrostatic breakdown and the productivity is not regarded because the beam has a different amount of current while has almost the same maximum current density in some cases as shown in figure 6. In figure 6, figure 6(a) shows a two-dimensional current density distribution and figure 6(b) shows a current density distribution of a section taken along a line A-A' in figure 6(a).

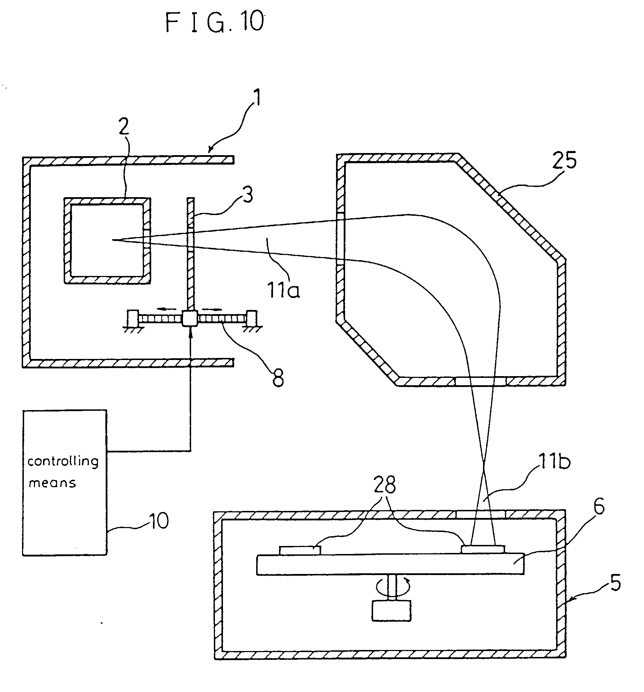

Figure 10 is a view showing a structure of an ion implantation apparatus in accordance with the preferred embodiment of the present invention. In figure 10, the same references designate the same or corresponding parts in figure 1. A controlling means 10 controls the distance between the arc chamber 2 and the drawing electrode 3 by quantization in accordance with a theoretical calculation using conception of normalization perveance at a beam drawing part.

Then, operation thereof will be describe in detail hereinafter.

Referring to figure 10, the ion beam 11a is drawn by the drawing electrode 3 from plasma generated by the arc chamber 2. The drawn beam 11a passes through the mass separator 25 and then the beam 11b of required ions is separated. Then, the beam 11b is introduced into the ion implantation chamber 5 and radiated to the wafer 28 arranged on the rotary disc 6.

As shown in the above "Ion Source Engineering", pp. 183 - 186, an angle of divergence $\omega$ of a most outer orbit particle at a position of the drawing electrode is represented by the following equation in a primary approximation when a space charge can be disregarded.

(i) Single hole electrode

$$\omega = \frac{1}{4} \frac{2a}{d} \mid 1 - \frac{5}{3} \frac{P}{Pc} \mid$$

where 2a is a length of an opening for drawing a beam and d is the distance between the arc chamber and the drawing electrode.

(ii) Slit electrode or the like

$$\omega = \frac{17}{12} \frac{a}{d} \mid 1 - \frac{25}{17} \frac{p}{Pc} \mid$$

where P is actual perveance at a beam drawing part, which is represented by the following equation.

$$P = I_{EX} / V^{3/2}$$

where $I_{EX}$ is a drawing current and V is an accelerating (drawing) voltage.

In addition, Pc is perveance at the beam drawing part obtained by a plane parallel plate approximate calculation, which is represented by the following equation.

$$Pc \fallingdotseq \frac{4\varepsilon_0}{9} \frac{S}{d^2} \left(\frac{2Ze}{m_i}\right)^{1/2}$$

where $\varepsilon_0$ is a dielectric constant of a vacuum, S is an opening area at the beam drawing part, Z is an ionization number, e is a prime charge and $m_i$ is mass of an ion. (In the above-described first embodiment, the equation of D which provides a minimum beam divergence angle is led from the value of P/Pc when $\omega$ is 0 in the above equation.)

In addition, the relation between the beam divergence angle $\omega$ and initial velocities of the beam in x and y directions $x_0'$ and $y_0'$ is as follows.

$$\begin{cases} x_0' = \tan\omega_x \\ \\ y_0 = \tan\omega_y \end{cases}$$

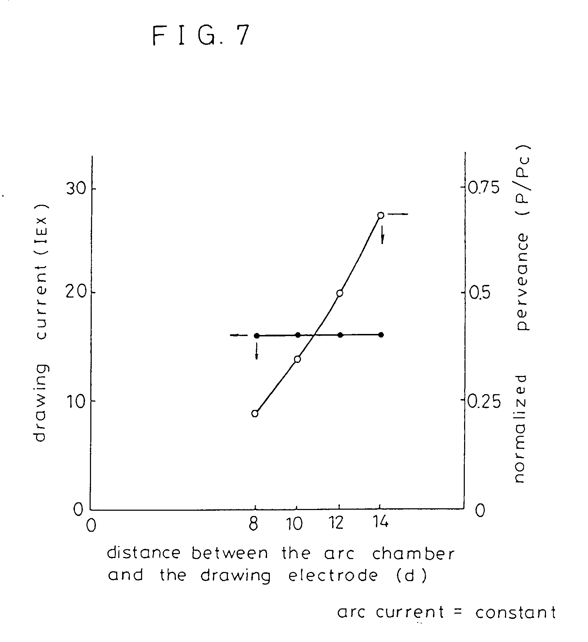

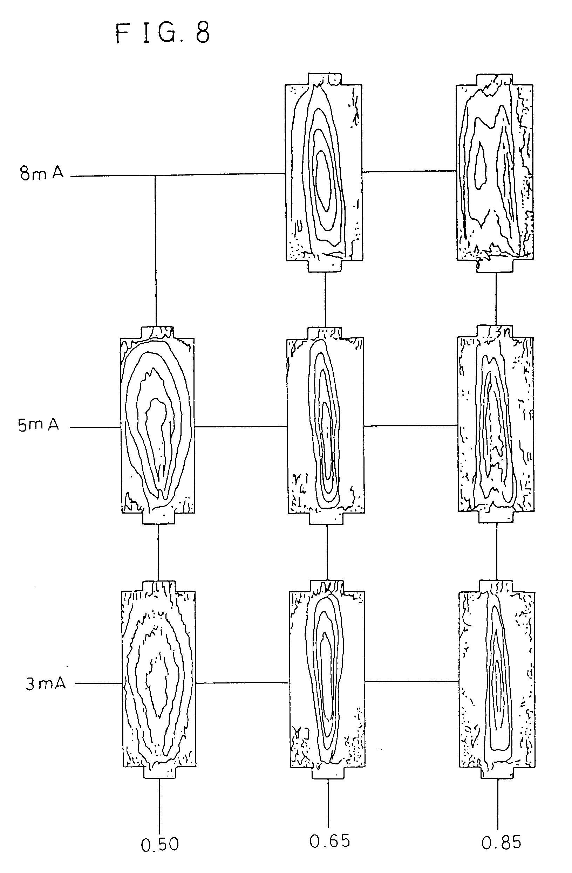

Therefore, when the position of the drawing electrode 3 and the normalized perveance P/Pc at the beam drawing part are found, the beam divergence angle $\omega$ is found. When the position and $\omega$ are found, a beam size on a wafer can be calculated, so that it is possible to control the beam size on the waver by controlling the value of P/Pc. However, the above calculation can not be applied as it is in some cases because of a difference in condition of a drawing system such as configuration of the drawing electrode in the actual ion implantation apparatus. In this case, fP/Pc multiplied by factor f peculiar to the apparatus may be used. It is found from the equation of P and Pc that P/Pc is varied when $I_{EX}$, V and d are varied. However, V is fixed at a constant value if a depth of implantation or the like is specified from the process side. Meanwhile, $I_{EX}$ is deeply concerned to an amount of implantation current and the amount of implantation current can be the subject of the control so that $I_{EX}$ should be used for controlling the amount of the implantation current. Therefore, the value of d may be used for controlling P/Pc. For example, as can be seen from figure 7, it is found that an arc current is constant in the ion implantation apparatus and when d varies from 8 mm to 14mm, P/Pc varies within the range 0.22 to 0.68, while the value of $I_{EX}$ is almost constant. The reason for this is that a plasma density is constant as far as the arc current is constant. In addition, it can be seen from figure 8 that the beam profile is almost the same as far as the value of P/Pc is the same even if $I_{EX}$ is different in some implantation apparatuses (it is considered that a difference in beam distribution due to the amount of current is caused by a space charge effect after the beam is drawn). Therefore, if the desired size of the beam on the wafer is set, the value of d is calculated by the calculating and controlling means 10 in accordance with a measured value of the amount of the drawing current or the like. Then, it is possible to control the beam 11 by moving the drawing electrode driving mechanism 8.

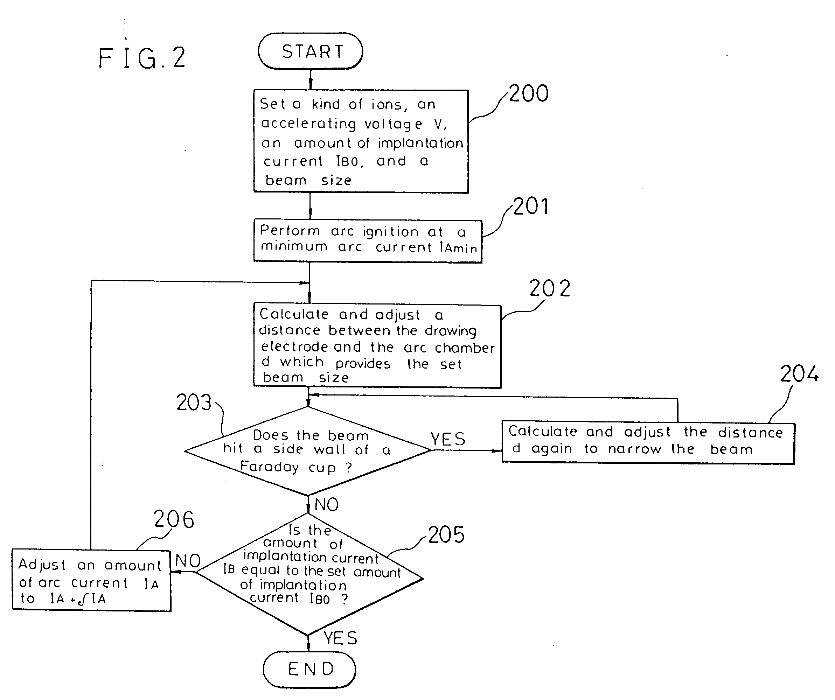

Figure 2 shows an example of control algorithm at this time.

First, a kind of ions, an accelerating voltage V, an amount of implantation current $I_{BO}$, and a beam size are set (200) and arc ignition is performed at a minimum arc current $I_{Amin}$ (201). Then, a distance between the drawing electrode and the arc chamber d which makes a divergence angle minimum is calculated and adjusted (202). If the ion beam hits a side wall of a Faraday cup, the distance d is repeatedly calculated and adjusted to narrow the beam until the beam which does not hit the side wall of the Faraday cup is obtained (203, 204). When an amount of implantation current $I_B$ is not equal to the set amount of implantation current $I_{BO}$ (205), an amount of arc current $I_A$ is adjusted to $I_A + \delta I_A$ (206), and the step returns to 202. The processing from 202 to below may be repeated until the amount of implantation current $I_B$ becomes equal to the set amount of implantation current $I_{BO}$.

Meanwhile, the beam divergence angle when the beam is drawn is controlled in the first embodiment and a phase coordinate of the beam on the wafer in the beam transporting system in this embodiment is found as follows using matrix representation shown in "ION BEAMS with application to ion implantation" pp.207 - 213.

$$\left.\begin{aligned} \begin{pmatrix} x \\ x' \end{pmatrix} &= (M_{L2})(M_{e2X})(M_{magX})(M_{e1X})(M_{L1}) \begin{pmatrix} x_0 \\ x_0' \end{pmatrix} \\ \\ \begin{pmatrix} y \\ y' \end{pmatrix} &= (M_{L2})(M_{e2Y})(M_{magY})(M_{e1Y})(M_{L1}) \begin{pmatrix} y_0 \\ y_0' \end{pmatrix} \end{aligned}\right\} \quad \cdots\cdots (1)$$

$$\left.\begin{aligned} (x_0 \ x_0') \\ (y_0 \ y_0') \end{aligned}\right\} \cdots \text{Initial phase coordinate}$$

$$x : \text{Horizontal direction}$$

$$y : \text{Vertical direction}$$

where (M) is a transfer matrix at each part and each of them is represented as follows.

$$(M_{L2}) = \begin{pmatrix} 1 & L2 \\ 0 & 1 \end{pmatrix}$$

: straight line from an analytical electromagnet outlet to a wafer and L2 is the distance between them.

$$(M_{e2x}) = \begin{pmatrix} 1 & 0 \\ -\tan\beta/\rho & 1 \end{pmatrix}$$

: caused by an effect of an end part of the analytical electromagnet outlet and $\beta$ is a beam outputting angle.

$$(M_{magx}) = \begin{pmatrix} \cos\phi & \rho\sin\phi \\ -\sin\phi/\rho & \cos\phi \end{pmatrix}$$

: an analytical electromagnet

$$(M_{e1x}) = \begin{pmatrix} 1 & 0 \\ -\tan\alpha/\rho & 1 \end{pmatrix}$$

: caused by an effect of an end part of an analytical electromagnet inlet and $\alpha$ is a beam incident angle.

$$(M_{L1}) = \begin{pmatrix} 1 & L1 \\ 0 & 1 \end{pmatrix}$$

: a straight line from an ion source to the analytical electromagnet inlet and L1 is the distance between them.

$$(M_{e2y}) = \begin{pmatrix} 1 & 0 \\ \tan\beta/\rho & 1 \end{pmatrix}$$

: caused by an effect of an end part of an analytical electromagnet outlet.

$$(M_{magy}) = \begin{pmatrix} 1 & \rho\phi \\ 0 & 1 \end{pmatrix}$$

: an analytical electromagnet

$$(M_{e1Y}) = \begin{pmatrix} 1 & 0 \\ \tan\alpha/\rho & 1 \end{pmatrix}$$

: caused by an effect of an analytical electromagnet inlet and $\rho$ is a radius of curvature and $\phi$ is an angle of polarization.

Therefore, the size of the beam on the wafer can be obtained by calculating a most outer orbit of a desired kind of ions among particles forming the ion beam using the above equation.

More specifically, it is also possible to control a value of (x, y, x', y') by varying the incident angle and the outputting angle of the mass separator 25 in accordance with the above equation (1).

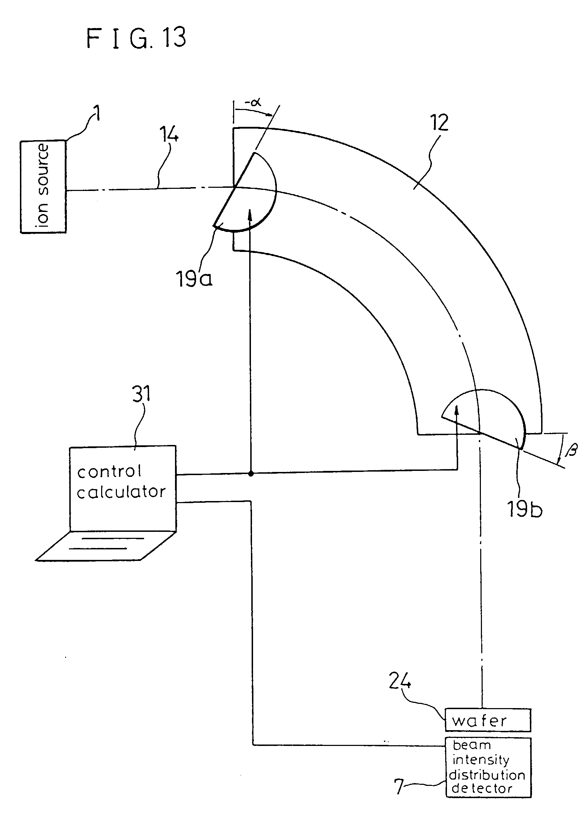

Figure 13 is a view showing a control structure of a mass separator in an ion implantation apparatus similar to, however not in accordance with the present invention. In figure 13, an ion beam is output from an ion source 1 and an optical axis thereof is curved by a mass analytical electromagnet 12. Then, the ion beam reaches a wafer 24 and a beam intensity distribution detector 7. A control calculator 31 controls an incident angle variable magnetic pole and an outputting angle variable magnetic pole of the mass analytical electromagnet 12 in accordance with an output of the beam intensity distribution detector 7.

Then, operation thereof will be described in detail hereinafter.

The ion implantation apparatus is variously used. For example, when a semiconductor is manufactured, it is used for forming a layer of a required atom by sputtering an ion on the wafer. The kind of ion implanted in the wafer is boron (B), arsenic (As) or the like. For example, when boron is implanted, first, gas of boron is introduced into the ion source 1 to be ionized and then drawn with required energy. However, there are unnecessary ions such as $^{10}B$ other than necessary ions of $^{11}B$ in the drawn boron beam. Therefore, the necessary ions of $^{11}B$ is separated from the various ions through the mass analytical electromagnet 12 and they reach the wafer. Although the required size of the beam on the wafer is determined by the size of the wafer, when the beam drawn out of the ion source 1 passes through a conventional mass separator, the beam outputting angle is variable but the beam incident angle is fixed, and therefore the beam control is performed either in x direction or y direction.

Therefore, the analytical electromagnet 12 in accordance with this embodiment comprises the incident angle variable magnetic pole 19a and the outputting angle variable magnetic pole 19b which have an effect of converging the beam in the horizontal and vertical directions and an automatic controller thereof in addition to a function as the mass separator.

References $\alpha$ and $\beta$ correspond to $\alpha$ and $\beta$ which are given in description of the equation which determines the coordinates. In figure 13, when the direction of an arrow is $\beta>0$, x converges and y diverges and when the direction of the arrow is $\alpha<0$, x diverges and y converges. More specifically, when both are positive, convergent force in the horizontal direction and divergent force in the vertical direction are applied and when they are negative, the reverse force thereof are applied. Movement of the particles in such a beam transporting system is described above and any beam size on the wafer can be obtained by varying the incident and outputting angles. Since the incident and outputting angles are variable in this embodiment, even in a case where a predetermined beam is not obtained or a case where the kind of ions, the accelerating voltage or the like are changed after the apparatus is manufactured, it is possible to provide a predetermined beam size on the wafer by appropriately varying both incident and outputting angles.

As described above, since values of the incident angled and the outputting angle $\beta$ are calculated and then the beam can be formed so as to converge both in the x and y directions in this embodiment, it is possible to automatically control the beam with high precision.

In addition, for example, when a divergent angle of the beam before it is applied to the mass separator 4 is controlled as small as possible by the drawing electrode and the beam is arranged by the incident and outputting angles $\alpha$ and $\beta$ by combining the control in accordance with the third embodiment and the position control of the drawing electrode 3 in accordance with the second embodiment, the beam transporting efficiency is increased and the beam can be controlled with high precision.

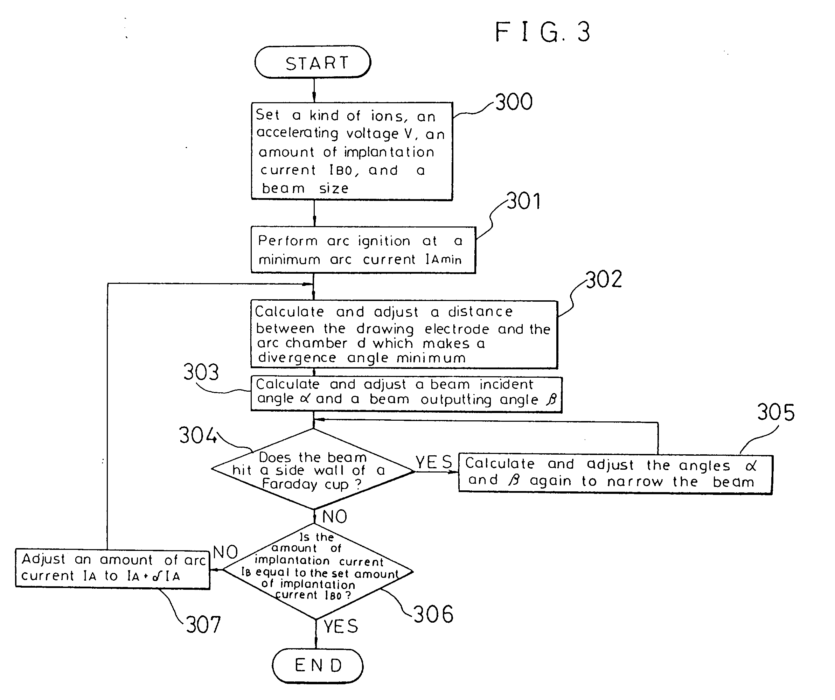

Figure 3 shows an example of control algorithm in this case.

First, a kind of ions, an accelerating voltage V, an amount of implantation current $I_{BO}$, and a beam size are set (300) and arc ignition is performed at a minimum arc current $I_{Amin}$ (301). Then, a distance between the drawing electrode and the arc chamber d which makes a divergence angle minimum is calculated and adjusted (302), and a beam incident angle $\alpha$ and a beam outputting angle $\beta$ are calculated and adjusted (303). If the beam hits a side wall of a Faraday cup, the beam incident angle $\alpha$ and the beam outputting angle $\beta$ are repeatedly calculated and adjusted to narrow the beam until the beam which does not hit the side wall of the Faraday cup is obtained (304, 305). When an amount of implantation current $I_B$ is not equal to the set amount of implantation current $I_{BO}$ (306), an amount of arc current $I_A$ is adjusted to $I_A + \delta I_A$ (307), and the step returns to 302. The processing from 302 to below may be repeated until the amount of implantation current $I_B$ becomes equal to the set amount of implantation current $I_{BO}$.

If the control by the drawing electrode 3 in this case is regarded as control for drawing a constant beam even if the ion source is varied, it can be considered that a range of control is increased. In addition, even if the control of the drawing electrode 3 and the control of the outputting angle $\beta$ (or the incident angle $\alpha$) are only combined, the range of control is increased as compared with the control of the outputting angle $\beta$ only.

Although the control is effective in a case where divergence caused by the effect of the space charge of the beam can be disregarded, if that effect can not be disregarded, it is necessary to use a calculation in which the effect of the space charge is considered. An outline of this calculating method is almost the same as above except that an influence of the space charge effect is approximated by a thin wall lens and taken into that calculation. More specifically, divergent force which is generated by the influence of the space charge when the beam advances by a distance 1 is considered that it is received in an instant after the beam advances by the distance 1. Therefore, it appears that a lens applying the divergent force in both horizontal and vertical directions is arranged in the beam transporting system at intervals of 1. When the electric charge density distribution of the beam is uniform, the transfer matrix of the thin wall lens is represented as follows.

$$\begin{pmatrix} 1 & 0 \\ \delta_{x,y} & 1 \end{pmatrix}$$

$$\delta_x = \varepsilon \frac{120el(1-\eta)}{m_0 c^2 \gamma^3 a(a+b)} 1$$

$$\delta_y = \varepsilon \frac{120el(1-\eta)}{m_0 c^2 \gamma^3 b(a+b)} 1$$

where $\varepsilon$ is electric charge number/mass number, $\eta$ is neutralization coefficient, $m_0 c^2$ is rest energy of proton, $\gamma$ is velocity of ion/velocity of light, a is a radius in the horizontal direction when a section of the beam is an ellipse and b is a radius in the vertical direction when the section of the beam is an ellipse.

As can be seen from the above, since the divergent force influenced by the space charge is related to a beam diameter, the divergent force is applied while the beam diameter is sequentially calculated along the beam orbit in the actual calculation. More specifically, the beam diameter when the beam advances from the ion source by a distance with regardless of an influence of the space charge is found and then the divergent force influenced by the space charge is found from that beam diameter using the above representation and then the divergent force is applied to the beam. Then, the same calculation is continued using the consequently changed form of emittance as an initial value. If the neutralization coefficient by electrons of the ion beam is previously found by an experiment or the like, the control can be more accurate.

As described above, the beam size on the wafer can be automatically controlled by the calculation, with the result that the beam current can be automatically controlled. However, when it is necessary to automatically control the current density distribution with higher precision than that of the above automatic control or when a non-linear effect of the beam can not be disregarded, feedback control may be used in accordance with the result measured by the current density distribution measuring apparatus 7.

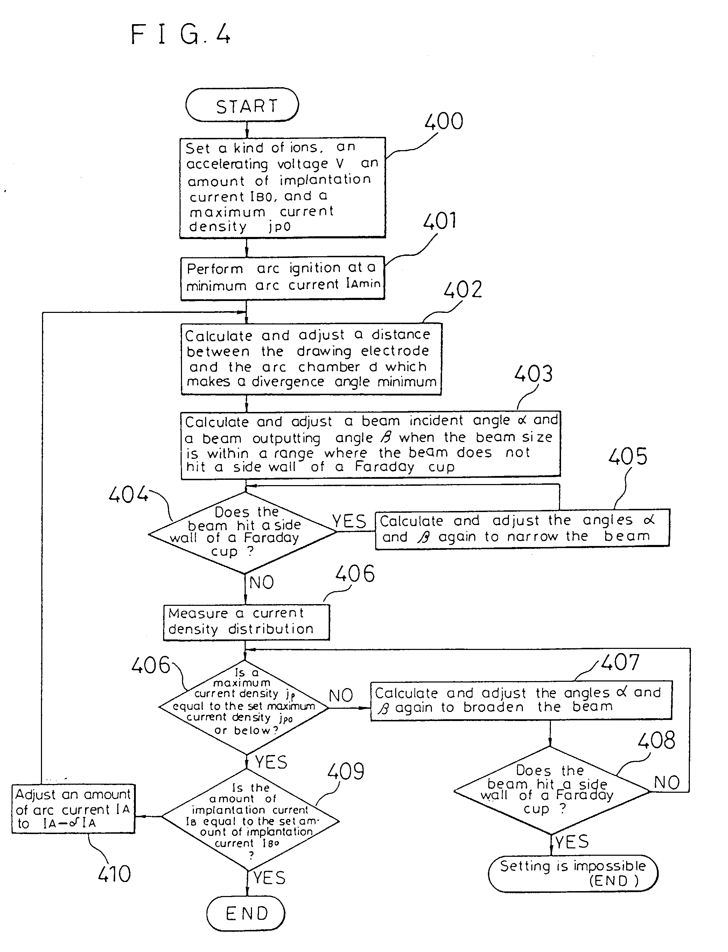

Figure 4 shows an example of control algorithm in this case.

First, a kind of ions, an accelerating voltage V, an amount of implantation current $I_{BO}$, and a maximum current density $j_{pO}$ are set (400) and arc ignition is performed at a minimum arc current $I_{Amin}$ (401). Then, a distance between the drawing electrode and the arc chamber d which makes a divergence angle minimum is calculated and adjusted (402), and a beam incident angle $\alpha$ and a beam outputting angle $\beta$ are calculated and adjusted when the beam size is within a range where the beam does not hit a side wall of a Faraday cup (403). If the beam still hits the side wall of the Faraday cup, the beam incident angle and the beam outputting angle $\beta$ are repeatedly calculated and adjusted to narrow the beam until the beam which does not hit the side wall of the Faraday cup is obtained (404, 405). Then, a current density distribution is measured (406), and when a maximum current density $j_p$ is higher than the set maximum current density $j_{pO}$, the beam incident angle $\alpha$ and the beam outputting angle $\beta$ is again calculated and adjusted to broaden the beam (407). If the beam still hits the side wall of the Faraday cup (408), it is judged that the setting is impossible and then the processing is concluded. When the maximum current density $j_p$ is equal to the set maximum current density $j_{p0}$ or below (406) and the amount of the implantation current $I_B$ is not equal to the amount of the set implantation current $I_{B0}$ (409), the amount of the arc current $I_A$ is adjusted to $I_A - \delta I_A$ (410), and the step returns to 402.

The processing from 402 to below may be repeated until the amount of the implantation current $I_B$ becomes equal to the amount of the set implantation current $I_{BO}$.

Although above-described control is performed with regard to an electrostatic breakdown coefficient only, when productivity needs to be increased, it is desirable that the amount of current is large and the electrostatic breakdown coefficient is low. Therefore, it is desirable to perform control the current density and the amount of implantation current at high level.

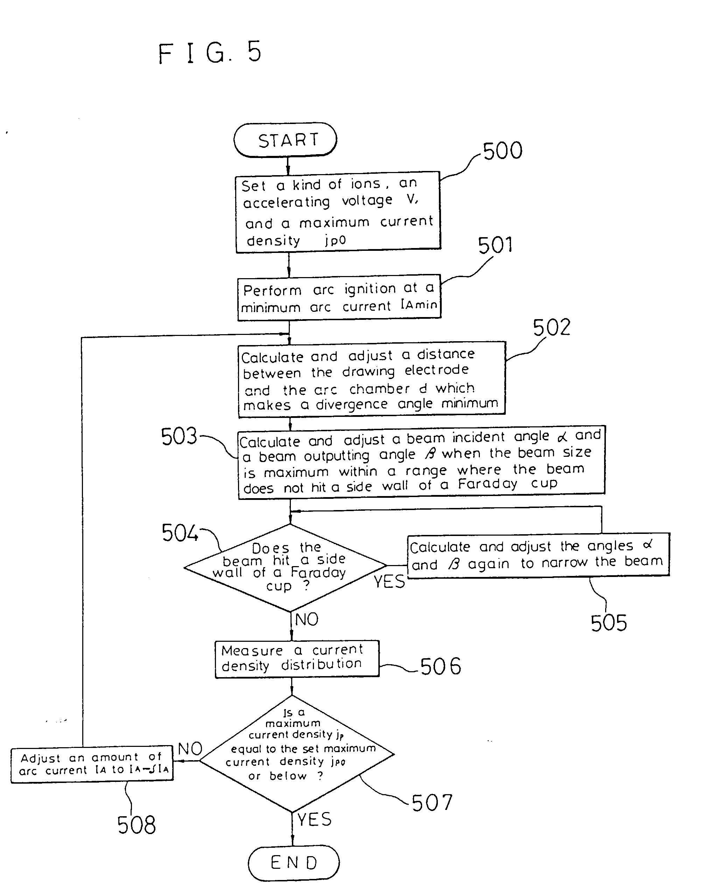

Figure 5 shows an example of automatic control algorithm in this case.

First, a kind of ions, an accelerating voltage V, an amount of implantation current $I_{BO}$, and a maximum current density $j_{p0}$ are set (500) and arc ignition is performed at a minimum arc current $I_{Amin}$ (501). Then, a distance between the drawing electrode and the arc chamber d which makes a divergence angle minimum is calculated and adjusted (502), and a beam incident angle $\alpha$ and a beam outputting angle $\beta$ are calculated and adjusted when the beam size is maximum within a range where the beam does not hit a side wall of a Faraday cup (503). If the beam still hits the side wall of the Faraday cup, the beam incident angle $\alpha$ and the beam outputting angle $\beta$ are repeatedly calculated and adjusted to narrow the beam until the beam which does not hit the side wall of the Faraday cup is obtained (504, 505). Then, a current density distribution is measured (506), and when a maximum current density $j_p$ is higher than the set maximum current density $j_{p0}$ (507), the amount of the arc current $I_A$ is adjusted to $I_A - \gamma I_A$ (508), and the step returns to 502. The processing from 502 to below may be repeated until the maximum current density $j_p$ becomes equal to the set maximum current density and below.

In this algorithm, a maximum amount of implantation current which does not exceed a value of a set maximum current density is obtained.

As a result, it is possible to provide an ion implantation apparatus having good yield and productivity as compared with the conventional implantation apparatus.

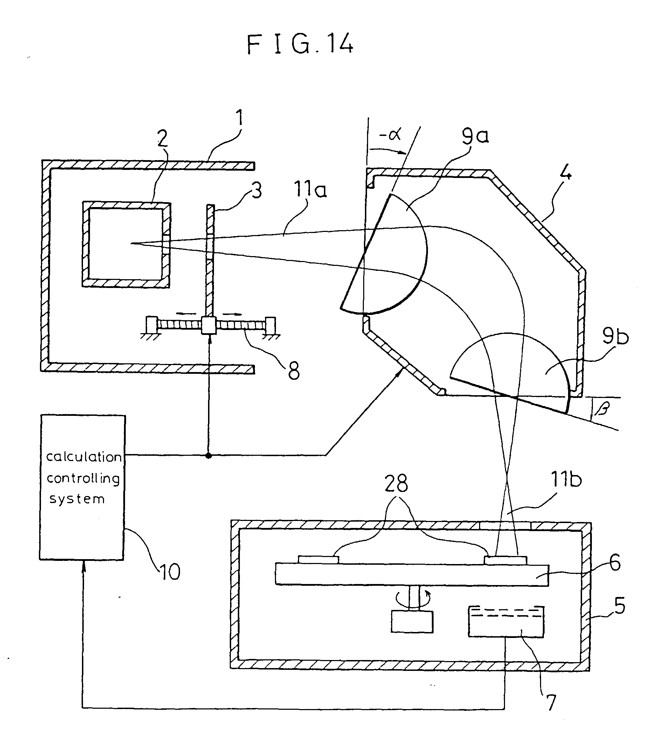

Figure 14 is a view showing a structure of an ion implantation apparatus similar to, however not in accordance with the present invention, which comprises ion beam measuring means for the above feedback control in addition to the means for controlling the distance between the arc chamber and the drawing electrode by quantization in accordance with the theoretical calculation using conception of perveance at the drawing part and the means for controlling the incident and outputting angles of the ion beam toward the mass separator by quantization in accordance with the above theoretical calculation. In figure 14, an ion source 1 comprises an arc chamber 2 generating ions and a drawing electrode 3 drawing ions from the arc chamber 2. A mass separator 4 comprising an incident angle variable mechanism 9a and an outputting angle variable mechanism 9b takes out an ion beam 11b having required ions from an ion beam 11a drawn by a drawing electrode 3 and then the ion beam 11b is applied to an ion implantation chamber 5. A rotary disc 6 is provided in the ion implantation chamber 5 and a wafer 28 is put on the rotary disc 6. An ion beam measuring means 7 is provided at the lower part of the rotary disc 6. A controlling means 10 controls a drawing electrode driving means 8, the incident angle variable mechanism 9a, and the outputting angle variable mechanism 9b in accordance with a data obtained by the ion beam measuring means 7.

The automatic control in accordance with the present invention can be applied to continuous control (serial control) in real time or to beam adjustment (batch process) performed at appropriate intervals of time.

In the automatic control using a value of P/Pc, a theoretical calculation may be made at a part of the apparatus or the calculation only may be made in another apparatus. Alternatively, the beam in accordance with the value of P/Pc may be measured to previously confirm the appropriate value of P/Pc and then the apparatus may just automatically control a value of d to a position in accordance with the value of P/Pc by setting that value.

The feedback control using the current density distribution measuring apparatus 7 may be used for correcting the theoretical calculation or the feedback control may be only used. In addition, although the conventional feedback control is performed by measuring the beam after mass separation, the automatic control can be performed by monitoring the beam before the mass separation. In this case, it is necessary to confirm correlation between beams after and before mass separation by a calculation or an experiment.

The same effect can be obtained in the automatic control using the maximum current density as a control parameter even if a maximum value of an accumulated current density of the wafer in the first scanning direction or the amount of implantation current to an element which is obtained by multiplying the accumulated current density by a lateral width of the element is used as the control parameter instead of the maximum current density.

It is assumed that the ion source is in a normal state (to a certain degree) in the automatic control described above. However, setting of the ion source is shifted when a filament is exchanged, causing axial shift of the drawing electrode and the beam drawing part of the arc chamber or wear of the filament is concentrated on an end part, causing large variation in plasma distribution in some cases. In that case, distribution of the implanted ion beam is largely -varied, with the result that the automatic control sometimes does not effectively work. Therefore, when there is large variation in the beam distribution found by the ion beam current density distribution measuring apparatus including a simple one in the ion implantation apparatus, alarm may be generated. When the alarm is given just after the ion source is set, the setting of the drawing electrode or the arc chamber is adjusted so as to remove the variation of the beam distribution or when the alarm is given several times after the ion source is set (a filament is exchanged), the filament may be exchanged even if the filament is not gone. Thus, there is no large variation in the beam distribution and then the above automatic control can effectively work.

In figures 2 and 3 showing the automatic control algorithm, the size of the beam is set in the first place. However, in view of reduction of the electrostatic breakdown coefficient, the beam may as well spread within a range where, for example the beam itself does not hit a side wall of a Faraday cup and an error in reading the amount of current does not occur. In addition, since this spread (that is, the beam size) is peculiar to the apparatus, the beam size may be stored in the calculation apparatus as a constant.

Although the present invention described above is mainly referred to an ion implantation apparatus used when the semiconductor is manufactured, it may be applied to an ion implantation apparatus used for another object (for example surface reforming of metal or the like) from the viewpoint of automatic control for uniformalizing the beam distribution.

According to the present invention, since an amount of current and a current density distribution of an ion beam is controlled by adjusting the distance between an arc chamber and a beam drawing electrode, an ion beam correcting lens can be dispensed with. As a result, beam transporting efficiency can be prevented from being reduced. In addition, since it is possible to adjust the distance between the arc chamber and the beam drawing electrode by quantization in accordance with a theoretical calculation using conception of normalization perveance at a beam drawing part, the control is possible even if there is no ion beam measuring means in an ion implantation chamber, with the result that the size of the apparatus can be reduced.

**Claims**

1. An ion implantation apparatus comprising:

   - an ion source (1) comprising an arc chamber (2) generating ions and a drawing electrode (3) drawing ion from said arc chamber (2);
   - a mass separator (25) transporting only such ions of the drawn ions which are necessary for implantation to a material into which ions shall be implanted;
   - an ion implantation chamber (5) in which said material is arranged; and
   - a controlling means for controlling the amount of current and the current density distribution of the ion beam provided by said ion source; wherein said controlling means (10) is arranged to adjust said amount of current and the current density distribution by controlling the distance (d) between said arc chamber (2) and said drawing electrode (3),

   **characterized in that**
   said controlling means (10) is arranged to

   - determine a divergence angle $\omega$ based on the beam size on the material into which ions are to be implanted: and
   - calculating the distance (d) based on said divergence angle $\omega$, the length 2a of the opening of the drawing electrode (3). and the normalized perveance P/Pc. whereby

$$P = I_{EX} / V^{3/2} \text{ and}$$

$$Pc = (4\varepsilon_0/9) (S/d^2) (2Ze/m_i)^{1/2},$$

   where $I_{EX}$ is the drawing current. V is the drawing voltage. $\varepsilon_o$ is the dielectric constant in vacuum, S is the opening area at the beam drawing part. Z is the ionization number, e is the prime charge and $m_i$ is the mass of an ion, from the following equation in the case of a single hole electrode:

$$\omega = (1/4) (2a/d) |1 - (5/3) (P/Pc)|$$

   or from the following equation in the case of a slit electrode:

$$\omega = (17/12) (a/d) |1 - (25/17) (P/Pc)|.$$

**2.** An ion implantation apparatus in accordance with claim 1. arranged to use instead of the term P/Pc the term fP/Pc, with f ≠ 1, and f depending on the configuration of the drawing electrode (3).

**Patentansprüche**

1. Ionenimplantationsgerät mit:

   - einer Ionenquelle (1) mit einer Ionen erzeugenden Bogenkammer (2) und einer Ziehelektrode (3), die Ionen aus dieser Bogenkammer (2) zieht;
   - einer Massentrenneinrichtung (25), die nur solche Ionen unter den gezogenen Ionen transportiert, die zur Implantation in ein Material erforderlich sind, in das Ionen implantiert werden sollen;
   - einer Ionenimplantationskammer (5), in der das Material angeordnet wird; und
   - einer Steuerungseinrichtung zum Steuern der Stromstärke und der Stromdichteverteilung des von der Ionenquelle gelieferten Ionenstrahls;
   - wobei die Steuerungseinrichtung (10) so ausgebildet ist, dass sie die Stromstärke und die Stromdichteverteilung dadurch einstellt, dass sie den Abstand (d) zwischen der Bogenkammer (2) und der Steuerelektrode (3) steuert; **dadurch gekennzeichnet, dass** die Steuerungseinrichtung (10) so ausgebildet ist, dass sie
   - einen Divergenzwinkel (ω) auf Grundlage der Strahlgröße am Material, in das Ionen zu implantieren sind, bestimmt; und
   - den Abstand (d) auf Grundlage des Divergenzwinkels ω, der Länge 2a der Öffnung der Ziehelektrode (3) und der normierten Perveanz P/Pc berechnet, wobei folgendes gilt:

$$P = I_{EX} / V^{3/2} \text{ und}$$

$$Pc = (4\varepsilon_0/9) \, (S/d^2) \, (2Ze/m_i)^{1/2},$$

   wobei $I_{EX}$ der Ziehstrom ist, V die Ziehspannung ist, $\varepsilon_0$ die Dielektrizitätskonstante im Vakuum ist, S die Öffnungsfläche am Strahlziehteil ist, Z die Ionisationszahl ist, e die Elementarladung ist und $m_i$ die Ionenmasse ist, wobei die folgende Gleichung im Fall einer Einzellochelektrode gilt:

$$\omega = (1/4) \, (2a/d)|1 - (5/3) \, (P/Pc)|,$$

   oder wobei im Fall einer Schlitzelektrode die folgende Gleichung gilt:

$$\omega = (17/12) \, (a/d)|1 - (25/17) \, (P/Pc)|.$$

2. Ionenimplantationsgerät nach Anspruch 1, das so ausgebildet ist, dass es anstelle des Terms P/Pc den Term fP/Pc verwendet, wobei f ≠ 1 gilt und f von der Konfiguration der Ziehelektrode (3) abhängt.

**Revendications**

1. Dispositif d'implantation d'ions comprenant :

   - une source d'ions comprenant une chambre à arc (2) générant des ions et une électrode d'extraction (3) extrayant des ions de ladite chambre à arc (2);
   - un séparateur de masse (25) transportant. parmi les ions extraits, uniquement ceux des ions qui sont nécessaires pour l'implantation à un matériau dans lequel des ions doivent être implantés;
   - une chambre d'implantation d'ions (5) dans laquelle ledit matériau est disposé; et
   - des moyens de contrôle pour contrôler la quantité de courant et la distribution de la densité de courant du faisceau d'ions fourni par ladite source d'ions; dans lequel lesdit moyens de contrôle (10) sont agencés pour régler ladite quantité de courant et la distribution de densité de courant en contrôlant la distance (d) entre ladite chambre à arc (2) et ladite électrode d'extraction (3), caractérisé en ce que lesdits moyens de contrôle

EP 0 701 269 B1

(10) sont agencés pour :
- déterminer un angle de divergeance $\omega$ basé sur la taille du faisceau sur matériau dans lequel des ions doivent être implantés; et
- calculer la distance (d) basée sur ledit angle de divergeance $\omega$, la longueur 2a de l'ouverture de l'électrode d'extraction (3), et la pervéance normalisée $P/P_c$, de telle manière que :

$$P = I_{EX} / V^{3/2}, \text{ et}$$

$$P_c = (4\varepsilon_0/9) (S/d^2) (2Ze/m_i)^{1/2},$$

où $I_{EX}$ est le courant d'extraction, V est la tension d'extraction, $\varepsilon_0$ est la constante dielectrique dans le vide, S est la surface d'ouverture à la partie d'extraction du faisceau, Z est le nombre d'ionisation, e est la charge initiale et $m_i$ est la masse d'un ion, à partir de l'équation suivante dans le cadre d'une électrode à un seul trou :

$$\omega = (1/4) (2a/d) |1 - (5/3) (P/P_c)|$$

ou de l'équation suivante, dans le cas d'une électrode à fente :

$$\omega = (17/12) (a/d) |1 - (25/17) (P/P_c)|$$

2. Un dispositif d'implantation d'ions selon la revendication 1, agencé pour utiliser à la place du terme $P/P_c$ le terme $fP/P_c$, avec $f \neq 1$, et f dépendant de la configuration de l'électrode d'extraction (3).

F I G. 1

controlling means

FIG.2

200 Set a kind of ions, an accelerating voltage V, an amount of implantation current IB0, and a beam size

201 Perform arc ignition at a minimum arc current IAmin

202 Calculate and adjust a distance between the drawing electrode and the arc chamber d which provides the set beam size

203 Does the beam hit a side wall of a Faraday cup ?

YES → 204 Calculate and adjust the distance d again to narrow the beam

NO → 205 Is the amount of implantation current IB equal to the set amount of implantation current IB0 ?

YES → END

NO → 206 Adjust an amount of arc current IA to IA + ∫IA

START

FIG. 3

```
                    ┌─────────────┐
                    │   START     │
                    └──────┬──────┘
                           │
         ┌─────────────────────────────────────┐  300
         │ Set a kind of ions, an              │
         │ accelerating voltage V, an          │
         │ amount of implantation              │
         │ current IB0, and a                  │
         │ beam size                           │
         └─────────────────┬───────────────────┘
                           │
         ┌─────────────────────────────────────┐  301
         │ Perform arc ignition at a           │
         │ minimum arc current IAmin           │
         └─────────────────┬───────────────────┘
                           │
         ┌─────────────────────────────────────┐  302
         │ Calculate and adjust a distance     │
         │ between the drawing electrode and the│
         │ arc chamber d which makes a         │
         │ divergence angle minimum            │
         └─────────────────────────────────────┘
  303    ┌─────────────────────────────────────┐
         │ Calculate and adjust a beam incident│
         │ angle α and a beam outputting angle β│
         └─────────────────┬───────────────────┘
                           │
  304          ◇ Does the beam ◇   YES  ┌──────────────────────┐  305
              ◇ hit a side wall of a ◇──────│ Calculate and adjust │
               ◇ Faraday cup ? ◇            │ the angles α         │
                      │                     │ and β again to narrow the beam │
                     NO                     └──────────────────────┘
                      │
              ◇ Is the ◇
   ┌──────────────┐ NO ◇ amount of ◇
   │ Adjust an amount of arc│◇ implantation current ◇
   │ current IA to IA+σIA   │◇ IB equal to the set amount ◇
   └──────────────┘   ◇ of implantation ◇
            307        ◇ current IB0 ? ◇    306
                           │
                          YES
                    ┌─────────────┐
                    │   END       │
                    └─────────────┘
```

# F I G. 4

```
                    ┌─────────────┐
                    │   START     │
                    └──────┬──────┘
                           │                              400
              ┌────────────┴──────────────┐
              │ Set a kind of ions, an     │
              │ accelerating voltage V  an │
              │ amount of implantation     │
              │ current IB0, and a         │
              │ maximum current            │
              │ density  jp0               │
              └────────────┬──────────────┘            401
              ┌────────────┴──────────────┐
              │ Perform  arc ignition at a │
              │ minimum arc current IAmin  │
              └────────────┬──────────────┘       402
              ┌────────────┴──────────────────┐
              │ Calculate and adjust a distance │
              │ between the drawing electrode   │
              │ and the arc chamber d which     │
              │ makes a divergence angle minimum│
              └────────────┬──────────────────┘         403
              ┌────────────┴─────────────────────────┐
              │ Calculate and adjust a beam incident  │
              │ angle α and a beam outputting angle β  │
              │ when the beam size is within a range   │
              │ where the beam does not hit a side     │
              │ wall of a Faraday cup                  │
              └────────────┬─────────────────────────┘
```

404 — Does the beam hit a side wall of a Faraday cup? — YES → 405 Calculate and adjust the angles α and β again to narrow the beam

NO

406 Measure a current density distribution

406 — Is a maximum current density $j_p$ equal to the set maximum current density $j_{p0}$ or below? — NO → 407 Calculate and adjust the angles α and β again to broaden the beam

YES

410 Adjust an amount of arc current IA to $IA - \delta IA$

409 — Is the amount of implantation current IB equal to the set amount of implantation current $IB_0$ ? — YES → END

408 — Does the beam hit a side wall of a Faraday cup? — NO

YES → Setting is impossible (END)

# F I G. 5

START

Set a kind of ions, an accelerating voltage V, and a maximum current density jp0 — 500

Perform arc ignition at a minimum arc current IAmin — 501

Calculate and adjust a distance between the drawing electrode and the arc chamber d which makes a divergence angle minimum — 502

503 — Calculate and adjust a beam incident angle $\alpha$ and a beam outputting angle $\beta$ when the beam size is maximum within a range where the beam does not hit a side wall of a Faraday cup

504 — Does the beam hit a side wall of a Faraday cup ?

Calculate and adjust the angles $\alpha$ and $\beta$ again to narrow the beam — 505

YES

NO

Measure a current density distribution — 506

Is a maximum current density jp equal to the set maximum current density jp0 or below ? — 507

NO

Adjust an amount of arc current IA to IA−$\delta$IA — 508

YES

END

# F I G. 6

(a) two-dimentional current density distribution
(contour map)

A ———— ———— A'

(b)

beam current 3mA

beam current 5mA

# F I G. 7

distance between the arc chamber
and the drawing electrode (d)

arc current = constant

F I G. 8

## FIG. 9

outputting angle

A

99

110

105

104

106

**ion beam current density distribution measuring means**

102

103

97

101

94

**probe position controlling means**

**analytical slit position controlling means**

111

109

**ion beam focal position calculating means**

112

108

93

**ion beam profile controlling means**

**ion implantation determining means**

92

100

107

**maximum ion beam current density setting means**

EP 0 701 269 B1

FIG.10

## F I G. 11

distance between the arc chamber
and the drawing electrode (d)

## F I G. 12

disc scanning direction

F I G. 13

ion source 1

14

-α

12

19a

31

control calculator

β

19b

24

wafer

7

beam intensity distribution detector

FIG.14

FIG.15

FIG.16

FIG.17